(19) Europäisches Patentamt
European Patent Office
Office européen des brevets

(11) EP 3 829 066 A1

(12) EUROPEAN PATENT APPLICATION

(43) Date of publication:
02.06.2021 Bulletin 2021/22

(51) Int Cl.:
H03K 19/0185 (2006.01)

(21) Application number: 19212625.8

(22) Date of filing: 29.11.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
KH MA MD TN

(71) Applicant: Socionext Inc.
Yokohama-shi Kanagawa 222-0033 (JP)

(72) Inventors:
• MIKHAEL, David Hany Gaied
63225 Langen (DE)
• GERMANN, Bernd Hans
63225 Langen (DE)

(74) Representative: Haseltine Lake Kempner LLP
Cheapside House
138 Cheapside
London
EC2V 6BJ (GB)

(54) **CLOCK DISTRIBUTION CIRCUITRY**

(57) Clock distribution circuitry (100) for distributing a clock signal across integrated circuitry, the clock distribution circuitry comprising: a clock transmitter (20) comprising first and second transmission nodes (22, 24) and configured to generate first and second currents, defining a transmitter differential clock signal, at the first and second transmission nodes, respectively; a clock receiver (30) comprising first and second reception nodes (32, 34) and first and second current paths (36, 38) which extend between the first and second reception nodes and a voltage supply node (VDD) via first and second clock output nodes (VOUT-, VOUT+), respectively, wherein first and second load impedances (RL1, RL2) are connected to form respective parts of the first and second current paths between the first and second clock output nodes and the voltage supply node, and first and second impedance-matching transistors (M3, M4) are connected to form respective parts of the first and second current paths between the first and second reception nodes and the first and second clock output nodes, respectively; and first and second transmission lines (TL1, TL2) connected between the first and second transmission nodes and the first and second reception nodes, respectively, to cause the first and second currents to flow along the first and second current paths and induce output voltage signals at the first and second clock output nodes, respectively, which define a receiver differential clock signal. The first and second impedance-matching transistors are configured so that the input impedances of the clock receiver at the first and second reception nodes substantially match the characteristic impedances of the first and second transmission lines, respectively.

FIG. 2

**Description**

The present invention relates to clock distribution circuitry, for example for distributing a clock signal within or across an integrated circuit (IC).

One possible application of such clock distribution circuitry may be in circuits in which clock signals need to be transmitted over distances sufficiently long that transmission lines are used and reflections affect performance. Examples of such a transmission distance include, for example, transmitting a clock signal from a printed circuit board contact pad to a phase locked loop (PLL), from a PLL to digital-to-analog converters (ADCs) and/or analog-to-digital converters (DACs), and from a PLL clock to a remote on-chip receiver. In such cases, a transmitter and receiver of the clock signal may be considered remote from one another.

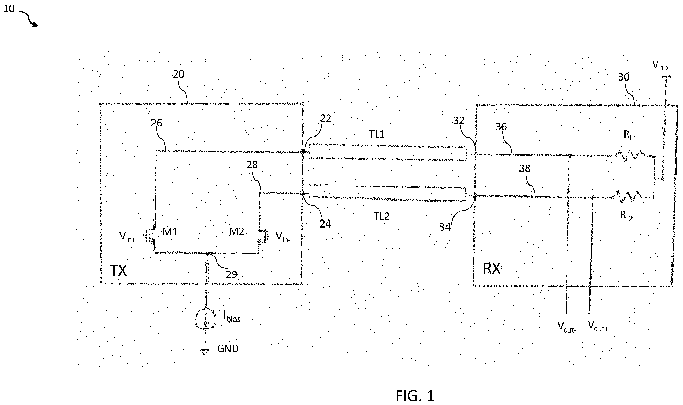

By way of background, a schematic diagram of a previously-considered clock distribution circuit 10 will now be considered with reference to **Figure 1** in order to explore merely one potential application of the present invention. The clock distribution circuit 10 comprises a clock transmitter (TX) 20 and a clock receiver (RX) 30 connected at opposite ends of transmission lines TL1, TL2.

The transmission lines TL1, TL2 may be understood to be two discrete or separate transmission lines connected between the clock transmitter 20 and the clock receiver 30. Alternatively, the transmission lines TL1, TL2 may be implemented together as a differential transmission line, and thus in Figure 1 be representative of two component parts of such a differential transmission line connected between the clock transmitter 20 and the clock receiver 30. References to the transmission lines TL1, TL2 hereinafter will be understood accordingly.

The clock distribution circuitry 10 is configured to transmit a differential clock signal from the clock transmitter 20 to the clock receiver 30. The clock receiver 30 comprises first and second current paths 36, 38 connected between the transmission lines TL1, TL2, respectively, and a first voltage source $V_{DD}$. The clock transmitter 20 comprises third and fourth current paths 26, 28 connected between transmission lines TL1, TL2, respectively, and a second voltage source GND.

Focusing first on the transmitter 20, the third and fourth current paths 26, 28 are connected to the first and second transmission lines TL1, TL2 via first and second transmission nodes 22, 24, respectively, such that first and second currents (which have an AC component, in this case with a DC offset) can flow along the third and fourth current paths 26, 28 and thus also along the transmission lines TL1, TL2, respectively. First and second differential-pair transistors M1, M2 are connected along the third and fourth current paths 26, 28 between the first and second transmission nodes 22, 24, respectively, and a tail node 29. A current source $I_{bias}$ is connected between the tail node 29 and the second voltage source GND.

The first and second differential-pair transistors M1, M2 are configured to receive first and second input voltage signals as the differential clock signal. That is, the first differential-pair transistor M1 is configured to receive a first input voltage signal at first input node $V_{in+}$ and convert the first input voltage signal into the first current that flows along the third current path 26. The second differential-pair transistor M2 is configured to receive a second input voltage signal at second input node $V_{in-}$ and convert the second input voltage signal into the second current that flows along the fourth current path 28. Effectively, a constant or regulated current $I_{bias}$ (i.e. a bias current) controlled by the current source $I_{bias}$ is steered between the third and fourth paths 26, 28 based on the differential clock signal, creating the first and second currents. The clock transmitter 20 is therefore configured to transmit the differential clock signal, in the form of the first and second currents, to the clock receiver 30 along the transmission lines TL1, TL2. The differential-pair transistors M1, M2 of the clock distribution circuit 10 illustrated in Figure 1 are NMOS MOSFET transistors.

Turning to the receiver 30, the first and second current paths 36, 38 are connected to the first and second transmission lines TL1, TL2 via first and second reception nodes 32, 34, respectively, such that the first and second currents flowing along the first and second transmission lines TL1, TL2 are received by the first and second transmission nodes 32, 34 and flow along the first and second current paths 36, 38, respectively. First and second load impedances $R_{L1}$, $R_{L2}$ are connected along the first and second current paths 36, 38, respectively, and are configured to convert the first and second currents into first and second output voltage signals. First and second clock output nodes $V_{out-}$, $V_{out+}$ are connected along the first and second current paths 36, 38, respectively, between the load impedances $R_{L1}$, $R_{L2}$ and the reception nodes 32, 34, and are configured to output the first and second output voltage signals as a received differential clock signal. The clock receiver 30 is therefore configured to receive the differential clock signal, in the form of the first and second currents, from the clock transmitter 20 via transmission lines TL1, TL2, and output the differential clock signal in the form of the first and second output voltage signals.

The first and second differential-pair transistors M1, M2 are configured to control the differential clock signal by steering the current supplied from the current source $I_{bias}$ into the first and second load impedances $R_{L1}$, $R_{L2}$.

When the first input voltage signal received at the first input node $V_{in+}$ is high (e.g. 1V), the whole of the current supplied from $I_{bias}$ is steered through the first differential-pair transistor M1 such that the first current becomes equivalent to $I_{bias}$ and the second current becomes 0. As a result, the first output voltage signal generated at the first clock output node $V_{out-}$ becomes equal to $V_{DD} - I_{bias}.R_{L1}$. Conversely, when the first input voltage signal received at the first input

node $V_{in+}$ is low (e.g. 0V), the first differential-pair transistor M1 is effectively turned off, which results in the current associated with the first current signal becoming equivalent to 0 and the first output voltage signal generated at the first clock output node $V_{out-}$ becoming equal to the voltage generated at the voltage supply node $V_{DD}$ (e.g. 5V). The second output voltage signal output at the second clock output node $V_{out+}$ is generated in a similar manner by controlling the second differential-pair transistor M2.

It will be appreciated from the above description of the clock distribution circuitry 10, that the maximum single-ended peak-to-peak voltage swing generated by the clock distribution circuitry 10 is equivalent to $I_{bias}.R_{L1}$ or $I_{bias}.R_{L2}$.

Despite the provision of a clock transmitter 20 and a clock receiver 30 to transmit a differential clock signal, the clock distribution circuitry 10 suffers from power losses and/or distortion/noise due to reflections generated in the transmission lines TL1, TL2.

The transmission lines TL1, TL2 used to transmit the currents associated with the first and second current signals are considered to be "long" signal lines that suffer from reflections. A transmission line in this case may be considered to have a length that is greater than 1/10 of the wavelength of the signal (in the present case, a clock signal) it is carrying, i.e. greater than $\lambda/10$ (where $\lambda$ = v/f, v = the velocity of the signal, and f = the frequency of the signal). In some instances lengths greater than $\lambda/4$ may be applicable. The clock signals considered here may be considered to have a clock frequency f, and thus a corresponding wavelength $\lambda$ which enables the length $\lambda/10$ (or $\lambda/4$) to be defined.

In order to avoid (or reduce) transmission line reflections, the first and second load impedances $R_{L1}$, $R_{L2}$ are designed to be equal to the characteristic impedance Zo of the first and second transmission lines TL1, TL2, respectively. This practice is commonly referred to as "impedance matching". Conventionally, the characteristic impedance of transmission lines is around 50$\Omega$, which restricts the impedances of the first and second load impedances $R_{L1}$, $R_{L2}$ to 50$\Omega$, such that the load impedances $R_{L1}$, $R_{L2}$ are equal to the characteristic impedances of the transmission lines TL1, TL2, respectively. Therefore, in order to generate a large output voltage swing at the first and second clock output nodes $V_{out-}$, $V_{out+}$, the first and second currents must be large because the load impedances $R_{L1}$, $R_{L2}$ are fixed to 50$\Omega$ (which is relatively small). The transmission of large currents across transmission lines causes high power consumption and produces increased losses compared to if smaller currents were used, which thereby reduces the efficiency of the clock distribution circuitry 10. Furthermore, the maximum single-ended output voltage swing of the clock distribution circuitry 10 is limited by the current rating of the transmission lines TL1, TL2, because the load impedances cannot be increased without causing reflections to occur (which would introduce noise/distortion). The maximum single-ended output voltage swing is therefore in practice limited to $I_{bias}.Z_o$ in clock distribution circuitry 10.

It is desirable to solve some or all of the above-mentioned problems.

According to an embodiment of a first aspect of the present invention, there is provided clock distribution circuitry for distributing a clock signal across integrated circuitry, the clock distribution circuitry comprising: a clock transmitter comprising first and second transmission nodes and configured to generate first and second currents, defining a transmitter differential clock signal, at the first and second transmission nodes, respectively; a clock receiver comprising first and second reception nodes and first and second current paths which extend between the first and second reception nodes and a voltage supply node via first and second clock output nodes, respectively, wherein first and second load impedances are connected to form respective parts of the first and second current paths between the first and second clock output nodes and the voltage supply node, and first and second impedance-matching transistors are connected to form respective parts of the first and second current paths between the first and second reception nodes and the first and second clock output nodes, respectively; and first and second transmission lines connected between the first and second transmission nodes and the first and second reception nodes, respectively, to cause the first and second currents to flow along the first and second current paths and induce output voltage signals at the first and second clock output nodes, respectively, which define a receiver differential clock signal. The first and second impedance-matching transistors are configured (or the clock distribution circuitry is configured, e.g. by virtue of sizing of the impedance-matching transistors, controlling of bias currents, and/or controlling of gate or base voltages) so that the input impedances of the clock receiver at the first and second reception nodes substantially match the characteristic impedances of the first and second transmission lines, respectively.

Thus, the introduction of first and second impedance-matching transistors between the first and second reception nodes and the first and second clock output nodes, respectively, may provide or enable improved impedance matching between the transmission lines and the clock receiver. The impedances of the clock receiver and the transmission lines may be matched by controlling the transconductances of the impedance-matching transistors, which may thereby allow the load impedances to be more freely adjusted to meet required design specifications. For example, in order to increase the output voltage swing, the first and second currents may be maintained at relatively low magnitudes and the load impedances may be increased in magnitude without introducing significant reflections to the transmission lines, due to an impedance mismatch. The impedance-matching transistors may thereby serve as an effective shield between the load impedances and the transmission lines in order to allow the load impedances to be varied without causing significant transmission line reflections.

The clock transmitter may be configured to control the first and second currents. For example, the first and second transmission nodes may be configured to receive first and second components of a differential signal, respectively, in which case the first and second currents may be controlled to be substantially proportional to the first and second components of a differential signal.

Substantially match may be taken to mean that the input impedances of the clock receiver, created mainly by (or dominated by) the first and second impedance-matching transistors, are substantially the same as the characteristic impedances of the first and second transmission lines, respectively. For example, in a case where the characteristic impedances of the transmission lines are 50Ω, the transconductances of the impedance-matching transistors are controlled to create clock receiver input impedances of 50Ω within tolerances.

The first and second transmission lines may be planar transmission lines, such as microstrip, stripline, embedded-microstrip or coplanar transmission lines. The planar transmission lines may be used to interconnect the clock transmitter and the clock receiver in an integrated circuit (such as in an IC chip) and/or on a printed circuit board.

The first and second reception nodes may be end terminals of the first and second transmission lines, respectively, and the first and second impedance-matching transistors may be connected (e.g. directly) at the first and second reception nodes to form respective parts of the first and second current paths.

The transmission lines may each comprise first and second end terminals, respectively, wherein the first end terminals may be connected to the first and second reception nodes and the second end terminals may be connected to the first and second transmission nodes.

Such a direct connection between the impedance-matching transistors and the reception nodes (i.e. the end terminals) may be taken to be an electrical connection having no other (discrete) components. For example, the impedance-matching transistors may be electrically connected to the reception nodes such that first and second currents flow uninterrupted from the reception nodes to the impedance-matching transistors without passing through any other (discrete) components, so that the interface between the characteristic impedances of the transmission lines and the input impedances of the of the clock receiver (as provided by the impedance-matching transistors) - at which reflections might occur - is at the reception nodes (i.e. the end terminals).

The sizes of the first and second impedance-matching transistors may be configured to define the transconductances of the first and second impedance-matching transistors, respectively. For example, the length-width ratio (W/L) of the impedance-matching transistors (consider, e.g. MOSFETs) may be configured such that the transconductances of those transistors are substantially proportional to the characteristic impedances of the transmission lines (e.g. 1/50Ω or 20mS).

The first and second transmission lines may be implemented as separate transmission lines, and said characteristic impedances of the first and second transmission lines may be the characteristic impedances of the respective separate transmission lines.

Separate may be taken to mean that the first and second transmission lines are discrete transmission lines, individual transmission lines and/or different transmission lines. For example, the first transmission line may be connected between the first transmission node and the first reception node, and the second transmission line may be connected between the second transmission node and the second reception node.

The first and second transmission lines may be implemented together as a differential transmission line, and said characteristic impedances of the first and second transmission lines may be each substantially equal to half of the differential characteristic impedance of the differential transmission line. For example, one end of the differential transmission line may be connected to both transmission nodes and the other end of the differential transmission line may be connected to both reception nodes, with each end having positive and negative terminals connected to the respective nodes at that end.

The control voltage signals may have the same voltage level as one another or different voltage levels from one another.

The impedance-matching transistors may be cascode transistors.

The clock transmitter may be configured to convert first and second input voltage signals into the first and second current signals.

The first and second currents may be defined by a bias current, and the clock distribution circuitry may comprise a current source configured to define the bias current so as to configure the transconductances of the first and second impedance-matching transistors, respectively. That is, the transconductances of the first and second impedance-matching transistors may be defined at least by the respective first and second currents defined by the bias current.

The current source may be a controllable current source, and the clock distribution circuitry may be configured to control the current source to control or vary the bias current. For example, the bias current may be controlled to adjust the first and second currents are thereby create transconductances of the impedance-matching transistors which are substantially proportional to the characteristic impedances of the transmission lines.

Said current source may be connected between the first and second transmission nodes and a second voltage source.

The clock transmitter may further comprise: third and fourth current paths which extend between the first and second transmission nodes and a second voltage source via a tail node; and first and second differential-pair transistors connected to form respective parts of the third and fourth current paths between the first and second transmission nodes and the tail node, respectively. The first differential-pair transistor and the first impedance-matching transistor may form (parts of) a first cascode circuit, and the second differential-pair transistor and the second impedance-matching transistor may form (parts of) a second cascode circuit. The current source may be connected between the tail node and the second voltage source.

The first and second differential-pair transistors may be configured to convert first and second input voltage signals into the first and second currents, respectively.

The impedance-matching transistors may be BJTs or FETs, and/or the differential-pair transistors may be BJTs or FETs.

The clock distribution circuitry of the aforementioned first aspect may be a clock buffer.

The first and second currents may have an AC component.

According to an embodiment of a second aspect of the present invention, there is provided integrated circuitry such as an IC chip comprising the clock distribution circuitry of the aforementioned first aspect.

Reference will now be made, by way of example, to the accompanying drawings, of which:

Figure 1, considered above, is a schematic diagram of clock distribution circuitry;
Figure 2 is a schematic diagram of clock distribution circuitry embodying the present invention;
Figure 3 is a graph illustrating voltage swings generated by clock distribution circuitry embodying the present invention; and
Figure 4 is a schematic diagram of integrated circuitry incorporating the clock distribution circuitry embodying the present invention.

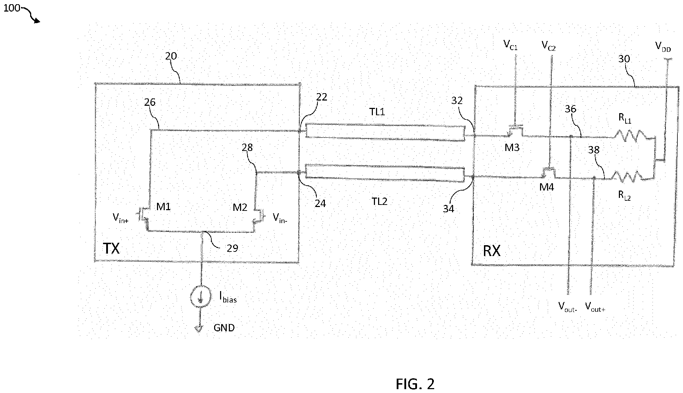

**Figure 2** is a schematic diagram of clock distribution circuitry 100 embodying the present invention. The basic configuration and operation of clock distribution circuitry 100 is the same as that of clock distribution circuitry 10, described above with reference to Figure 1 and like elements are denoted with like reference signs. Therefore, a description of the basic configuration and operation of clock distribution circuitry 100 will be omitted for brevity. The clock distribution circuitry 100 may be referred to as a clock buffer.

Clock distribution circuitry 100 differs from clock distribution circuitry 10 in that the clock receiver 20 further comprises first and second impedance-matching transistors M3, M4. The first and second impedance-matching transistors M3, M4 are connected along the first and second current paths 36, 38, respectively, between the load impedances $R_{L1}$, $R_{L2}$ and the reception nodes 32, 34 of their respective current paths 36, 38, respectively.

The first and second impedance-matching transistors M3, M4 interact with the first and second differential-pair transistors M1, M2 to form respective cascode circuits. The first differential-pair transistor M1 and the first impedance-matching transistor M3 may be referred to as a first cascode circuit, and the second differential-pair transistor M2 and the second impedance-matching transistor M4 may be referred to as a second cascode circuit. Further, the first and second impedance-matching transistors M3, M4 may be referred to as cascode transistors. The differential-pair transistors M1, M2 and/or the impedance-matching transistors M3, M4 may be implemented as BJT transistors and/or field-effect (e.g. MOSFET) transistors. When implemented as MOSFETs, the differential-pair transistors M1, M2 and the impedance-matching transistors M3, M4 may be NMOS MOSFETs, as illustrated in Figure 2, or PMOS MOSFETs, in which case the clock distribution circuitry 100 would be inverted.

In certain embodiments of the present invention, the load impedances $R_{L1}$, $R_{L2}$ may be discrete resistors, a current source active load with common mode feedback, or an inductive-capacitive (LC) load. As such, the load impedances $R_{L1}$, $R_{L2}$ may be referred to as load impedances $Z_{L1}$, $Z_{L2}$, respectively, and the present disclosure will be understood accordingly.

The input impedance of the clock receiver 30 seen by the transmission lines TL1, TL2 can be calculated based on the input impedances of the impedance-matching transistors M3, M4 and the load impedances $R_{L1}$, $R_{L2}$.

The clock receiver input impedance seen by the first transmission line TL1 can be illustrated by equation (1) below:

$$R_{in(TL1)} = \frac{1}{g_{m(M3)}} + \frac{R_{L1}}{1 + g_{m(M3)} \cdot r_{o(M3)}} \approx \frac{1}{g_{m(M3)}} \qquad (1)$$

where $g_{m(M3)}$ is the transconductance of the first impedance-matching transistor M3, $R_{L1}$ is the first load impedance, and $r_{o(M3)}$ is the first impedance-matching transistor M3 output resistance.

Similarly, the clock receiver input impedance seen by the second transmission line TL2 can be illustrated by equation (2) below:

$$R_{in(TL2)} = \frac{1}{g_{m(m4)}} + \frac{R_{L1}}{1 + g_{m(M4)} \cdot r_{o(M4)}} \approx \frac{1}{g_{m(M4)}} \qquad (2)$$

As can be seen from equations (1) and (2), the input impedance of the clock receiver 30 seen by the transmission lines TL1, TL2 is dominated by the transconductances of the impedance-matching transistors M3, M4. Thus, the load impedances $R_{L1}$, $R_{L2}$ can be made arbitrarily larger than the characteristic impedances of the transmission lines with the impedance-matching transistors M3, M4 configured and controlled such that $1/g_m = Z_o$, for impedance matching. That is, the characteristic impedances of the transmission lines TL1, TL2 can be matched at the clock receiver 30 by using impedance-matching transistors M3, M4 having transconductances set based on the characteristic impedances. For example, first and second transmission lines TL1, TL2 each having a characteristic impedance of 50Ω may be matched at the clock receiver 30 using impedance-matching transistors M3, M4 each having a transconductance of 20mS (or 1/50 Ω), which thereby produce effective clock receiver input impedances of 50Ω for each transmission line TL1, TL2. Providing a means for increasing load impedances $R_{L1}$, $R_{L2}$ without causing transmission line reflections enables an output voltage swing equivalent to $I_{bias}.R_L$ to be made (much) larger than $I_{bias}.Z_o$, so that smaller currents are required to generate the desired output voltage swing.

In some embodiments of the present invention, the transmission lines TL1, TL2 may be implemented as, planar transmission lines, such as microstrip, stripline, embedded-microstrip or coplanar transmission lines.

The transconductances of the impedance-matching transistors M3, M4 may be controlled by using transistors that are manufactured to a specific size. For example, impedance-matching transistors M3, M4 having length-width ratios which generate a particular transconductance (e.g. 1/50 Ω) at a particular gate or base voltage may be selected. The transconductances of the impedance-matching transistors M3, M4 may also be controlled by varying (controlling) the first and second currents in order to generate the desired transconductances. For example, the current source $I_{bias}$ may be controlled (e.g. by an external control signal) such that the constant or regulated bias current $I_{bias}$ that creates the first and second currents may be varied. By controlling the current source to vary the first and second currents, the transconductances of the first and second impedance-matching transistors M3, M4 can be controlled to match the characteristic impedances of the first and second transmission lines TL1, TL2, respectively. In practice, both the sizes of the transistors M3, M4 and the first and second currents (in particular, the bias current $I_{bias}$) will be considered when matching the characteristic impedances.

The gate voltage or base voltage of the impedance-matching transistors M3, M4 are controlled by control voltage signals $V_{C1}$ and $V_{C2}$, respectively, in order to ensure that both transistors remain in the saturation region. In a case where the transconductances are controlled by selecting impedance-matching transistors M3, M4 of a certain size, the control voltage signals $V_{C1}$, $V_{C2}$ may be fixed to a constant voltage.

The transconductance of the impedance-matching transistors M3, M4 may be further controlled to an extent by varying (controlling) the control voltage signals $V_{C1}$, $V_{C2}$ in order to generate the desired transconductances.

Advantageously, using the first and second impedance-matching transistors M3, M4 to perform impedance matching at the clock receiver 30 allows the load impedances $R_{L1}$, $R_{L2}$ to be increased without introducing (or increasing) reflections in the transmission lines TL1, TL2. By providing a means to increase load impedance without introducing transmission line reflections, the output voltage swing of the clock distribution circuitry 100 can be increased without requiring large currents to be transmitted along transmission lines TL1, TL2, which have associated losses. That is, the output voltage swing can be increased by increasing the load impedances $R_{L1}$, $R_{L2}$ instead of increasing the currents transmitted along the transmission lines TL1, TL2. Therefore, the clock distribution circuitry 100 provides a means for increasing output voltage swing without detrimentally affecting circuit operating efficiency.

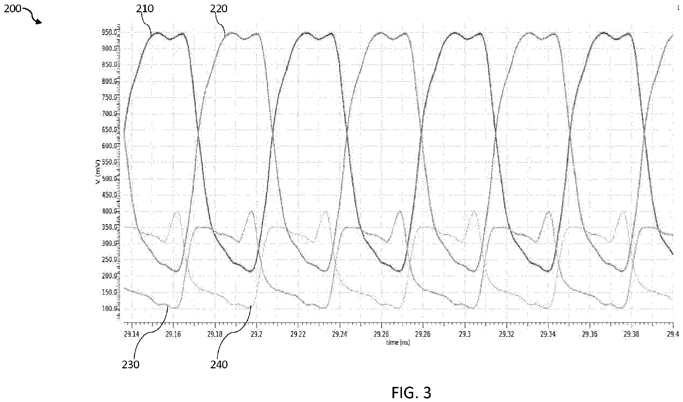

Furthermore, by transmitting smaller currents along transmission lines TL1, TL2, the voltage swing across the transmission lines TL1, TL2 is smaller than the output voltage swing generated at the first and second output nodes $V_{out-}$, $V_{out+}$. The reduced voltage swing across the transmission lines TL1, TL2 leads to fewer coupling issues that may occur as a result of the transmission lines TL1, TL2 travelling for relatively long distances when incorporated in an IC chip. A comparison of output voltage swing generated at the first and second output nodes $V_{out-}$, $V_{out+}$ (and seen at the load impedances $R_{L1}$, $R_{L2}$) vs voltage swing across the transmission lines TL1, TL2 is provided in Figure 3.

**Figure 3** is a graph 200 illustrating output voltage swing at the output nodes $V_{out-}$, $V_{out+}$ and voltage swing across transmission lines TL1, TL2. The y-axis of the graph 200 represents voltage in "mV" and the x-axis of the graph 200 represents time in "ns". The graph illustrates voltage traces 210, 220, 230 and 240 which were obtained from a design example of clock distribution circuitry 100, where $I_{bias} = 4mA$ and the characteristic impedances of the transmission lines TL1, TL2 is 50Ω.

The output voltage swings across the first and second clock output nodes $V_{out-}$, $V_{out+}$ are illustrated by traces 210 and 220, respectively, as being up to 750mV. The voltage swing across the transmission lines TL1, TL2 can be calculated as follows:

$$V_{TL} = I_{TL}.Z_0 = 4 \times 10^{-3}.50 = 200mV$$

The voltage swings across the transmission lines TL1, TL2 are also illustrated by traces 230 and 240 of Figure 3. Traces 230 and 240 show that there are some reflections which are illustrated by voltage spikes between 300mV and 400mV. If the voltage spikes are ignored, the voltage swing across the transmission lines TL1, TL2 is taken to be between 200mV and 250mV, i.e. close to the theoretical value of 200mV. Therefore, the difference in voltage swing between the voltages measured at the clock output nodes $V_{out-}$, $V_{out+}$ and the transmission lines TL1, TL2 is a factor of 3.75 (i.e. almost a factor of 4 improvement) when considering the theoretical swing of 200mV across the transmission lines TL1, TL2, or a factor of between 3 and 3.75 when considering the design example swing of 200mV to 250mV across the transmission lines TL1, TL2.

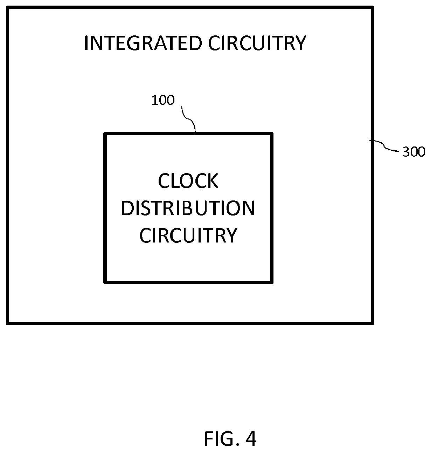

It will be appreciated that clock distribution circuitry 100 embodying the present invention may be implemented as integrated circuitry, for example on an IC chip such as flip chip. The present invention extends to integrated circuitry and IC chips as mentioned above, circuit boards comprising such IC chips, and communication networks (for example, internet fiber-optic networks and wireless networks) and network equipment of such networks, comprising such circuit boards. In particular, **Figure 4** illustrates clock distribution circuitry 100 implemented as integrated circuitry 300.

The present invention may be embodied in many different ways in the light of the above disclosure, within the spirit and scope of the appended claims.

**Claims**

1. Clock distribution circuitry for distributing a clock signal across integrated circuitry, the clock distribution circuitry comprising:

    a clock transmitter comprising first and second transmission nodes and configured to generate first and second currents, defining a transmitter differential clock signal, at the first and second transmission nodes, respectively;
    a clock receiver comprising first and second reception nodes and first and second current paths which extend between the first and second reception nodes and a voltage supply node via first and second clock output nodes, respectively, wherein first and second load impedances are connected to form respective parts of the first and second current paths between the first and second clock output nodes and the voltage supply node, and first and second impedance-matching transistors are connected to form respective parts of the first and second current paths between the first and second reception nodes and the first and second clock output nodes, respectively; and
    first and second transmission lines connected between the first and second transmission nodes and the first and second reception nodes, respectively, to cause the first and second currents to flow along the first and second current paths and induce output voltage signals at the first and second clock output nodes, respectively, which define a receiver differential clock signal,
    wherein the first and second impedance-matching transistors are configured so that the input impedances of the clock receiver at the first and second reception nodes substantially match the characteristic impedances of the first and second transmission lines, respectively.

2. The clock distribution circuitry according to claim 1, wherein the first and second transmission lines are planar transmission lines, such as microstrip, stripline, embedded-microstrip or coplanar transmission lines.

3. The clock distribution circuitry according to claim 1 or claim 2, wherein the first and second reception nodes are end terminals of the first and second transmission lines, respectively, and wherein the first and second impedance-matching transistors are connected at the first and second reception nodes to form respective parts of the first and second current paths.

4. The clock distribution circuitry according to any preceding claim, wherein:

    the first and second transmission lines are implemented as separate transmission lines, and said characteristic impedances of the first and second transmission lines are the characteristic impedances of the respective separate transmission lines; or
    the first and second transmission lines are implemented together as a differential transmission line, and said characteristic impedances of the first and second transmission lines are each substantially equal to half of the differential characteristic impedance of the differential transmission line.

5.  The clock distribution circuitry according to any preceding claim, wherein the first and second currents are defined by a bias current, and wherein the clock distribution circuitry comprises a current source configured to define the bias current so as to configure the transconductances of the first and second impedance-matching transistors, respectively.

6.  The clock distribution circuitry according to claim 5, wherein the current source is a controllable current source, and the clock distribution circuitry is configured to control the current source to control or vary the bias current.

7.  The clock distribution circuitry according to claim 5 or 6, wherein said current source is connected between the first and second transmission nodes and a second voltage source.

8.  The clock distribution circuitry according to any of claims 5 to 7, the clock transmitter further comprising:

    third and fourth current paths which extend between the first and second transmission nodes and a second voltage source via a tail node; and
    first and second differential-pair transistors connected to form respective parts of the third and fourth current paths between the first and second transmission nodes and the tail node, respectively,

    wherein:
    the first differential-pair transistor and the first impedance-matching transistor form parts of a first cascode circuit, and the second differential-pair transistor and the second impedance-matching transistor form parts of a second cascode circuit.

9.  The clock distribution circuitry according to claim 8, wherein the current source is connected between the tail node and the second voltage source.

10. The clock transmitter circuitry according to claim 8 or 9, wherein the first and second differential-pair transistors are configured to convert first and second input voltage signals into the first and second currents, respectively.

11. The clock distribution circuitry according to any preceding claim, wherein:

    the impedance-matching transistors are BJTs or FETs, and/or
    the differential-pair transistors are BJTs or FETs.

12. The clock distribution circuitry according to any preceding claim being a clock buffer.

13. The clock distribution circuitry according to any preceding claim, wherein the first and second currents have an AC component.

14. Integrated circuitry such as an IC chip comprising the clock distribution circuitry as claimed in any of the preceding claims.

FIG. 1

FIG. 2

FIG. 3

INTEGRATED CIRCUITRY

100

CLOCK
DISTRIBUTION
CIRCUITRY

300

FIG. 4

**EP 3 829 066 A1**

Europäisches Patentamt
European Patent Office
Office européen des brevets

# EUROPEAN SEARCH REPORT

Application Number

EP 19 21 2625

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 224 905 B1 (LIN CHIA-LIANG [US] ET AL) 5 March 2019 (2019-03-05)<br>* column 3, line 3 - column 5, line 12; figure 1A * | 1-14 | INV.<br>H03K19/0185 |
| X | JP H07 79231 B2 (FUJITSU LTD) 23 August 1995 (1995-08-23)<br>* paragraph [0001] *<br>* page 2, right-hand column - page 3, right-hand column; figures 1, 2 * | 1-14 | |
| A | YOSHIKAWA T ET AL: "Current-mode transceiver with nonfeedback clock recovery capability for mobile applications",<br>IEICE TRANSACTIONS ON ELECTRONICS, INSTITUTE OF ELECTRONICS, TOKYO, JP, vol. E91C, no. 9,<br>1 September 2008 (2008-09-01), pages 1453-1462, XP001515777,<br>ISSN: 0916-8524, DOI: 10.1093/IETELE/E91-C.9.1453<br>* page 1453, paragraphs 1.,2.; figure 2 *<br>* page 1454, paragraph 3.; figure 4 *<br>* page 1455, paragraph 4.1; figure 5 * | 1-14 | |
| A | WO 2019/055067 A1 (INTEL IP CORP [US]) 21 March 2019 (2019-03-21)<br>* page 7, line 13 - page 8, line 31; figure 3 * | 1-14 | |

**TECHNICAL FIELDS SEARCHED (IPC)**

H03K
H04L
G06F

The present search report has been drawn up for all claims

| Place of search | Date of completion of the search | Examiner |
|---|---|---|
| Munich | 8 May 2020 | Martínez Martínez, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

13

## ANNEX TO THE EUROPEAN SEARCH REPORT
## ON EUROPEAN PATENT APPLICATION NO.

EP 19 21 2625

This annex lists the patent family members relating to the patent documents cited in the above-mentioned European search report.
The members are as contained in the European Patent Office EDP file on
The European Patent Office is in no way liable for these particulars which are merely given for the purpose of information.

08-05-2020

| Patent document cited in search report | | Publication date | Patent family member(s) | | Publication date |
|---|---|---|---|---|---|
| US 10224905 | B1 | 05-03-2019 | CN 110417399 A<br>TW 201946384 A<br>US 10224905 B1 | | 05-11-2019<br>01-12-2019<br>05-03-2019 |
| JP H0779231 | B2 | 23-08-1995 | JP S631211 A<br>JP H0779231 B2 | | 06-01-1988<br>23-08-1995 |
| WO 2019055067 | A1 | 21-03-2019 | NONE | | |

EPO FORM P0459

For more details about this annex : see Official Journal of the European Patent Office, No. 12/82